# FASCICULE DE BREVET EUROPEEN

(11) **EP 3 182 537 B1**
(45) Date de publication et mention de la délivrance du brevet: **02.01.2019**
(21) Numéro de dépôt: 16200063.2
(22) Date de dépôt: 22.11.2016
(51) Int. Cl.: H02B 1/20

(54) **GOULOTTE DE CÂBLES ARTICULÉE**
GELENKIGER KABELKANAL
ARTICULATED CABLE DUCT

(30) Priorité: 16.12.2015 FR 1562507
(43) Date de publication de la demande: 21.06.2017
(73) Titulaire: Schneider Electric Industries SAS, 92500 Rueil-Malmaison (FR)
(72) Inventeur: MARMONIER, Jean, 34130 Saint Aunes (FR)
(74) Mandataire: Brevalex

(56) Documents cités:
- FR-A1- 2 819 114
- US-A1- 2002 160 660
- US-A1- 2009 200 057

## Description

### DOMAINE TECHNIQUE

L'invention concerne une armoire basse tension renfermant des modules électriques d'entrées/sorties portés par un rail standardisé de type DIN. De tels modules servent à relier des capteurs et des actionneurs présents sur une installation, avec des entrées et sorties d'un automate programmable et/ou d'un relais de protection et/ou d'une unité terminale distante.

### ÉTAT DE LA TECHNIQUE ANTÉRIEURE

Ce type d'armoire peut notamment être utilisé dans des systèmes de protection des réseaux électriques moyenne et haute tension, qui doivent mesurer en permanence des données électriques, telles que mesures de courants et tensions, délivrées par des transformateurs de courant et de tension installés sur des conducteurs de ces réseaux électriques.

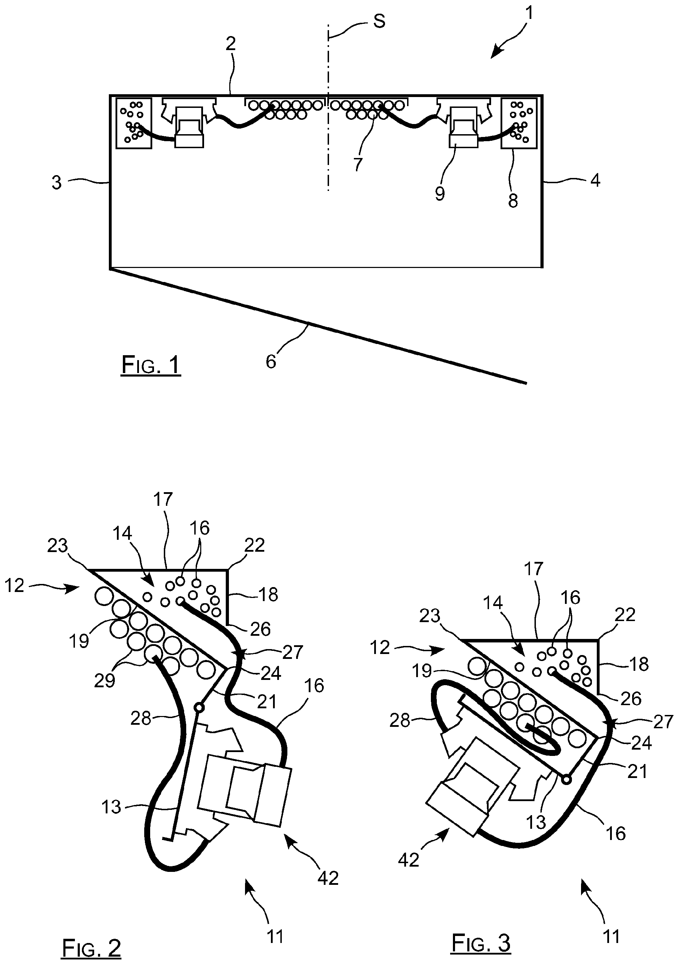

Une telle armoire basse tension connue 1 représentée en coupe en vue de dessus sur la figure 1, comprend un caisson incluant un fond plan 2 prolongé par deux flancs 3, 4, avec une porte 6. Les équipements de cette armoire sont portés par son fond 2 en étant répartis de façon symétrique par rapport à un plan vertical S séparant le fond en deux moitiés.

La moitié de droite de cette armoire comprend un chemin de câbles 7 s'étendant verticalement dans la région centrale du fond, une goulotte 8 longeant le flanc 4, et des modules 9 disposés verticalement les uns au-dessus des autres entre le chemin de câbles 7 et la goulotte 8. La moitié gauche du fond 2 porte les mêmes éléments agencés de façon symétrique par rapport au plan S.

Les modules 9 sont ainsi reliés d'une part aux capteurs et actionneurs du système en étant raccordés aux câbles du chemin de câbles 7, et d'autre part à un automate programmable en étant raccordés aux conducteurs électriques que porte la goulotte 8.

Dans cet agencement, le nombre de modules pouvant être implantés est limité principalement par la hauteur de l'armoire, ce qui limite d'autant le nombre d'entrées et de sorties. Des systèmes de goulottes intégrés dans les armoires basse tension sont déjà connus des brevets FR2819114 et US2002/0160660.

Le but de l'invention est de proposer une solution permettant d'augmenter le nombre d'entrées et de sorties dans une armoire de faibles dimensions.

### EXPOSÉ DE L'INVENTION

A cet effet, l'invention a pour objet une goulotte pour armoire basse tension, comprenant un corps incluant un fond et une paroi intermédiaire délimitant conjointement un compartiment ayant une ouverture permanente s'étendant le long d'un côté de la goulotte, et un rabat articulé sur le corps au niveau du côté de goulotte dans lequel est délimitée l'ouverture permanente, ce rabat étant mobile pour être rabattu en vis-à-vis de la paroi intermédiaire ou écarté de celle-ci, le compartiment étant destiné à recevoir des câbles de communication, la paroi intermédiaire étant destinée à porter des câbles de puissance sur sa face opposée au compartiment, le rabat étant destiné à porter sur sa face opposée à la paroi intermédiaire des modules connectés chacun à au moins un câble de communication et à au moins un câble de puissance.

Avec cet agencement, les câbles de communication, les câbles de puissance, et les modules raccordés à ces câbles sont superposés les uns aux autres, ce qui offre une grande compacité, tout en permettant à un opérateur d'accéder facilement à ces différents composants. Le nombre de modules, et par là même le nombre d'entrées et de sorties, peut ainsi être augmenté pour une taille de caisson d'armoire donnée.

L'invention concerne également une goulotte ainsi définie, dans laquelle le corps est formé par une tôle pliée pour constituer le fond et la paroi intermédiaire.

L'invention concerne également une goulotte ainsi définie, dans laquelle le corps comprend un flanc délimitant le compartiment conjointement avec le fond et la paroi intermédiaire, ce flanc s'étendant dans le prolongement du fond du côté opposé à la paroi intermédiaire, ce flanc s'étendant à angle droit par rapport au fond, la paroi intermédiaire ayant une orientation oblique par rapport au fond.

L'invention concerne également une goulotte ainsi définie, dans laquelle la paroi intermédiaire comporte des trous destinés à recevoir des colliers de fixation de câbles de puissance.

L'invention concerne également une goulotte ainsi définie, dans laquelle le rabat est formé par une tôle articulée sur le corps et portée par celui-ci en étant emboîtée sur ce corps.

L'invention concerne également une goulotte ainsi définie, comprenant un revers s'étendant dans le prolongement de la paroi intermédiaire en étant replié par rapport à cette paroi intermédiaire, ce revers comportant des ouvertures ou fenêtres destinées à recevoir des pattes correspondantes dépassant d'un bord du rabat pour assurer l'emboîtement du rabat sur le corps et son articulation.

L'invention concerne également une armoire, comprenant au moins une goulotte ainsi définie.

### BRÈVE DESCRIPTION DES DESSINS

La figure 1 déjà décrite est une vue en coupe d'une armoire basse tension connue de l'Etat de la technique ;
La figure 2 est une vue en coupe d'une goulotte selon l'invention lorsqu'elle est ouverte ;
La figure 3 est une vue en coupe d'une goulotte selon l'invention lorsqu'elle est fermée ;
La figure 4 est une vue en perspective d'une goulotte selon l'invention lorsqu'elle est ouverte ;
La figure 5 est une vue en perspective d'une goulotte selon l'invention lorsqu'elle est fermée ;
La figure 6 est une vue en perspective montrant l'accouplement du rabat sur le corps d'une goulotte selon l'invention ;
La figure 7 est une vue en perspective de la structure d'une goulotte selon l'invention ;
La figure 8 est une vue en coupe d'un premier mode de réalisation d'armoire basse tension selon l'invention ;
La figure 9 est une vue en coupe d'un second mode de réalisation d'armoire basse tension selon l'invention.

### EXPOSÉ DÉTAILLÉ DE MODES DE RÉALISATION PARTICULIERS

L'idée à la base de l'invention est de prévoir une même goulotte portant de façon superposée les câbles de communication ainsi que les câbles de puissance et les modules connectés à ces câbles pour présenter une compacité élevée. Grâce à cette structure empilée et autonome que constitue une telle goulotte, plusieurs goulottes peuvent être implantées de façon modulaire dans une même armoire, ce qui permet d'accroître le nombre de modules pouvant être installés dans une armoire de dimensions données.

La goulotte selon l'invention qui est représentée sur la figure 2 en y étant repérée par 11 comporte un corps 12 en tôle pliée portant un rabat en tôle 13 généralement plan qui est articulé sur ce corps 12. Cette goulotte 11 a une forme s'étendant longitudinalement qui est destinée à être implantée verticalement dans une armoire basse tension, plusieurs goulottes selon l'invention pouvant être installées côte à côte dans une telle armoire.

Le corps 2 de cette goulotte 11 est une tôle comprenant plusieurs pliages parallèles longitudinaux délimitant un compartiment 14 partiellement fermé dans lequel sont logés un ensemble de câbles de communication de données 16.

Ce corps 12 comporte un fond 17 situé entre un flanc 18 replié à angle droit par rapport à ce fond, et une paroi intermédiaire 19 oblique par rapport au fond 17, cette paroi intermédiaire étant prolongée par un revers 21. Le compartiment 14 présente ainsi une section généralement triangulaire délimité par le fond 17, le flanc 18 et la paroi intermédiaire 19.

Le fond 17 s'étend ainsi entre un premier pliage 22 et un second pliage 23, qui séparent respectivement, le fond 17 du flanc 18, et le fond 17 de la paroi intermédiaire 19.

La paroi intermédiaire 19 est inclinée à environ trente ou quarante degrés par rapport au fond autour du pliage 23, de façon à être en vis-à-vis de ce fond 17. Elle présente un bord libre, correspondant à un troisième pliage 24 délimitant le revers 21, qui est situé en vis-à-vis du flanc 18 et à distance du bord libre 26 de ce flanc 18, de manière à former une ouverture longitudinale permanente 27 du compartiment 14.

Les câbles de communication de données 16 peuvent ainsi être librement engagés dans le compartiment 14 de la goulotte en étant glissés dans l'ouverture permanente 27 qui s'étend sur toute la longueur de cette goulotte entre son flanc 18 et la paroi intermédiaire 19.

Comme visible sur les figures 2 et 3, la paroi intermédiaire 19 porte une série de câbles de puissance 28 logés dans des gaines 29 fixés à sa face externe, c'est-à-dire sa face qui est opposée au compartiment 14 qu'elle délimite.

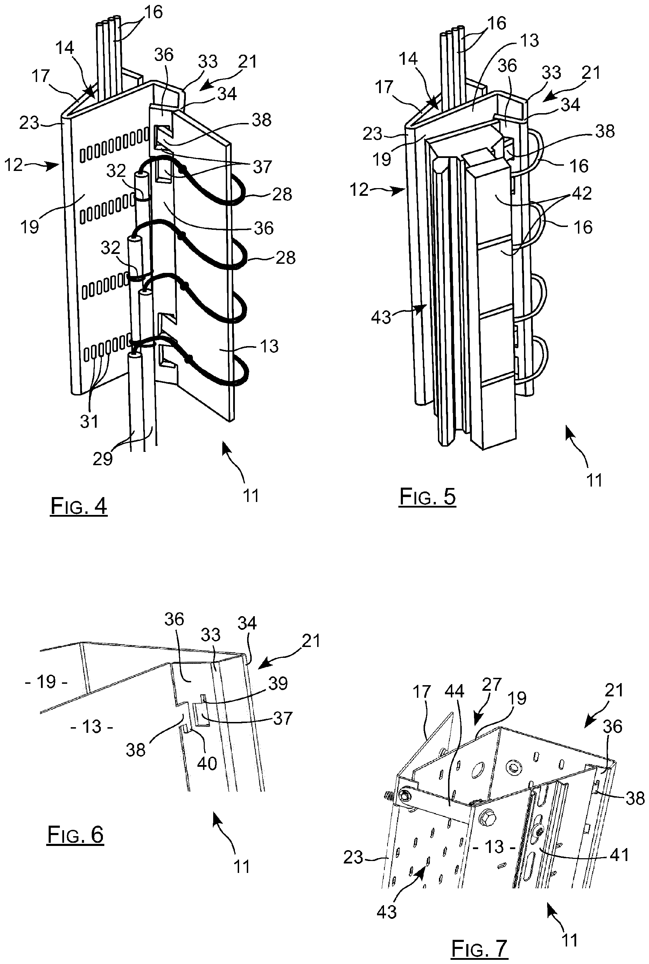

Cette paroi intermédiaire en tôle 19 est avantageusement ajourée par des séries de trous 31 dans lesquels peuvent être passés des colliers d'accrochage 32 de fixation des gaines 29 renfermant les câbles de puissance 28. Ces colliers 32 étant par exemple des colliers autobloquants en matière plastique, comme représenté schématiquement sur les figures 4 et 5.

Avantageusement, la tôle utilisée pour fabriquer la goulotte est une tôle zinguée, ce qui permet de réaliser une cage de protection électromagnétique des câbles de communication par rapport aux câbles de puissance.

Le bord libre de la paroi intermédiaire 19 est replié à angle droit au niveau du pliage 24, pour former le revers 21 qui comporte lui-même deux autres pliages 33 et 34 parallèles à la direction longitudinale de la goulotte. Ce revers présente une section transversale ayant la forme de la lettre U raccordée par l'une de ses branches à la portion intermédiaire via le pliage 24.

La portion libre de ce revers 21, repérée par 36 et qui s'étend sur toute la longueur de la goulotte en étant à une distance de la paroi intermédiaire 19 qui correspond sensiblement à l'épaisseur globale des gaines 29 que porte cette paroi intermédiaire 19.

Cette portion libre 36 comprend une série d'ouvertures ou fenêtres 37 régulièrement espacées les unes des autres, de forme généralement rectangulaires. Ces fenêtres 37 sont destinées à recevoir des pattes correspondantes 38 dépassant d'un bord du rabat 13 de façon à porter ce rabat 13 pour qu'il soit articulé sur le corps 12. Ce rabat 13 est ainsi mobile entre une position écartée de la paroi intermédiaire 19 comme dans les figures 2 et 4, et une position rabattue en vis-à-vis de la paroi intermédiaire 19 contre les gaines 29, comme dans les figures 3 et 5 où il s'étend parallèlement à cette paroi intermédiaire.

Comme visible de façon plus détaillée sur la figure 6, les fenêtres 37 peuvent avantageusement présenter un contour rectangulaire ayant un bord latéral prolongé vers le haut par une encoche 39 permettant l'engagement d'une patte 38, et les pattes 38 peuvent comporter complémentairement un ergot de retenue 40 s'étendant vers le bas dans le prolongement de leur bord libre. Dans ces conditions, l'engagement d'une patte 38 consiste à la positionner en vis-à-vis du bord de fenêtre 37 prolongé par une encoche 39, et à la pousser dans cette fenêtre pour qu'elle s'y bloque en étant retenue dans celle-ci par l'ergot 40.

Le rabat 13 porte sur sa face externe, à savoir sa face opposée à la paroi intermédiaire lorsqu'il est rabattu vers celle-ci, un rail standardisé de type DIN, repéré par 41 et s'étendant parallèlement à la direction longitudinale de la goulotte 11, des modules 42 fixés les uns au-dessus des autres à ce rail. Chaque module 42 est raccordé à au moins un câble de communication 16 et à au moins un câble de puissance 28.

Plus particulièrement, et comme visible sur les figures 3 et 5, chaque module 42 est raccordé à un câble de communication 16 dont l'extrémité sort du compartiment 14 via l'ouverture permanente 27. De manière analogue, chaque module est raccordé à un câble de puissance 28 porté par la paroi intermédiaire 19 et dont l'extrémité sort de la région située entre la paroi intermédiaire 19 et le rabat 13 en passant par une autre ouverture permanente 43 délimitée par le bord libre du rabat 13 de la paroi intermédiaire 19.

Comme visible sur la figure 7, la goulotte 11 est avantageusement pourvue de pattes ou écarteurs 44 portés par la paroi intermédiaire au voisinage du pli 23. Chaque écarteur 44 s'étend perpendiculairement à la paroi intermédiaire pour présenter une extrémité libre à laquelle est fixé le rabat 13 au voisinage de son bord libre, au moyen d'un boulon. Cette fixation ou immobilisation du rabat 13 est réalisée une fois que l'ensemble des modules 42 qu'il porte ont été connectés aux câbles de puissance 28.

D'une manière générale, la goulotte selon l'invention permet de doubler le nombre de modules et de connexions pouvant être installés dans un caisson d'armoire de dimensions données comme par exemple celle de l'Etat de la technique représentée en figure 1.

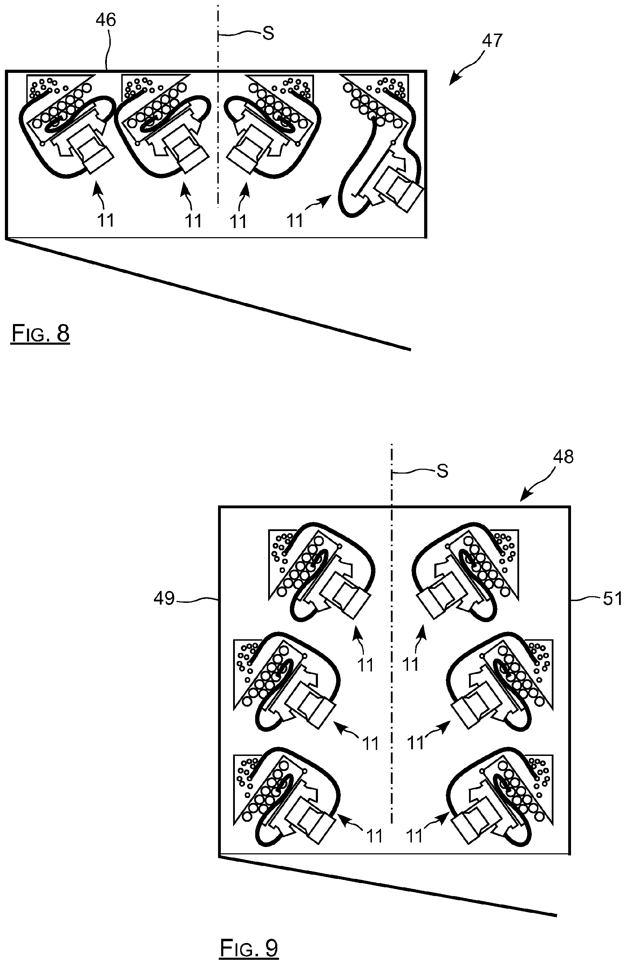

Plus concrètement, et comme représenté sur la figure 8, quatre goulottes selon l'invention peuvent être fixées au fond 46 d'un caisson d'armoire 47 de mêmes dimensions que celui de la figure 1. Comme le montre la figure 8, chaque goulotte 11 est fixée par son fond au fond 46 du caisson 47, de sorte que les rabats 13 de ces goulottes avec les modules 42 qu'ils portent sont situés en vis-à-vis de la face avant de ce caisson d'armoire.

Par ailleurs, les deux goulottes 11 montées en partie droite du caisson d'armoire, par rapport à son plan de symétrie S, sont fixées par leurs fonds au fond 46 de ce caisson. Les modules que portent ces goulottes sont ainsi orientés vers la partie centrale de la face avant de l'armoire, compte tenu de l'orientation oblique des parois intermédiaires des goulottes qui les portent par rapport à l'orientation des fonds de ces goulottes.

Le montage est symétrique pour les deux goulottes 11 montées en partie gauche du caisson : chaque goulotte de la partie gauche est montée tête en bas par rapport aux goulottes de la partie droite de façon à inverser l'orientation des modules qu'elles portent. Autrement dit, grâce à cette inversibilité des goulottes selon la direction verticale, les modules portés par les goulottes de gauche et ceux portés par les goulottes de droite sont tous orienté de façon convergent vers la région centrale de la face avant du caisson d'armoire.

Dans le cas d'un caisson d'armoire ayant une profondeur double, comme le caisson d'armoire 48 représenté sur la figure 9, trois goulottes peuvent être fixées à chacun des flancs 49, 51 de ce caisson. Compte tenu de l'orientation oblique de la paroi intermédiaire de chaque goulotte 11 par rapport à son fond 17, et par là même de l'orientation oblique des modules 42 portés par le rabat 13 parallèle à la paroi intermédiaire 13, les goulottes peuvent être agencées pour que les différents modules soient orientés vers la portion centrale et avant du caisson.

Dans ces conditions, malgré la compacité relativement élevée des équipements montés dans l'armoire 48, les différents rabats peuvent tous être ouverts pour permettre à un opérateur de monter et de connecter les câbles de puissance aux différents modules de chacune des six goulottes.

De même que dans l'exemple de la figure 8, dans l'agencement de la figure 9, les goulottes montées en partie gauche du caisson sont inversées par rapport à celles qui sont montées en partie droite, pour que tous les modules soient orientés de façon convergente vers la portion centrale de la face avant de l'armoire. L'accessibilité aux différents modules en est de fait facilitée.

Par ailleurs, le fait de placer les câbles de communication 16 dans le compartiment 14 permet d'équiper en usine la goulotte avec les modules 42 et les câbles de communication 16 connectés à ces modules. Sur site, il reste alors uniquement à installer la goulotte prééquipée et à fixer les câbles de puissance et à les connecter aux modules qu'elle porte. Ceci est encore facilité par le fait que les câbles de puissance 28 ainsi que les modules 42 sont situés en partie avant de la goulotte, c'est-à-dire du côté opposé à son fond. Une autre possibilité consiste à également monter les goulottes prééquipées dans l'armoire pour la connecter directement sur site.

En pratique, lors de l'installation sur site, les rabats 13 portant les modules 42 d'une même armoire sont successivement ouverts pour donner accès à la paroi intermédiaire afin d'y fixer les câbles de puissance 28, pour les connecter aux modules 42 avant de refermer le rabat qui les porte et de le fixer avec les pattes ou écarteurs 44.

Un autre avantage de l'invention est qu'elle permet de rapprocher les modules 42 de la face avant de l'armoire basse tension ainsi équipée, ce qui facilite la lecture d'information présentes sur des afficheurs ou écrans équipant ces modules.

## Revendications

1. Goulotte (11) pour armoire basse tension, comprenant un corps (12) incluant un fond (17) et une paroi intermédiaire (19) délimitant conjointement un compartiment (14) ayant une ouverture permanente (27) s'étendant le long d'un côté de la goulotte (11), **caractérisée par** un rabat (13) articulé sur le corps (12) au niveau du côté de goulotte dans lequel est délimitée l'ouverture permanente (27), ce rabat (13) étant mobile pour être rabattu en vis-à-vis de la paroi intermédiaire (19) ou écarté de celle-ci, le compartiment (14) étant destiné à recevoir des câbles de communication (16), la paroi intermédiaire (19) étant destinée à porter des câbles de puissance (28) sur sa face opposée au compartiment (14), le rabat (13) étant destiné à porter sur sa face opposée à la paroi intermédiaire (19) des modules (42) connectés chacun à au moins un câble de communication (16) et à au moins un câble de puissance (28).

2. Goulotte selon la revendication 1, dans laquelle le corps (12) est formé par une tôle pliée pour constituer le fond (17) et la paroi intermédiaire (19).

3. Goulotte selon la revendication 2, dans laquelle le corps (12) comprend un flanc (18) délimitant le compartiment (14) conjointement avec le fond (17) et la paroi intermédiaire (19), ce flanc (18) s'étendant dans le prolongement du fond (17) du côté opposé à la paroi intermédiaire (19), ce flanc (18) s'étendant à angle droit par rapport au fond (17), la paroi intermédiaire (19) ayant une orientation oblique par rapport au fond (17).

4. Goulotte selon la revendication 2, dans laquelle la paroi intermédiaire (19) comporte des trous (31) destinés à recevoir des colliers de fixation (32) de câbles de puissance (28).

5. Goulotte selon la revendication 2, dans laquelle le rabat (13) est formé par une tôle articulée sur le corps (12) et portée par celui-ci en étant emboîtée sur ce corps (12).

6. Goulotte selon la revendication 5, comprenant un revers (21) s'étendant dans le prolongement de la paroi intermédiaire (19) en étant replié par rapport à cette paroi intermédiaire (19), ce revers (21) comportant des ouvertures ou fenêtres (37) destinées à recevoir des pattes correspondantes (38) dépassant d'un bord du rabat (13) pour assurer l'emboîtement du rabat (13) sur le corps (12) et son articulation.

7. Armoire basse tension comprenant au moins une goulotte (11) selon l'une des revendications précédentes.

## Patentansprüche

1. Kabeldurchführung (11) für Niederspannungs-Schaltschränke, umfassend einen Körper (12) mit einem Boden (17) und einer Zwischenwand (19), die gemeinsam ein Fach (14) mit einer Daueröffnung (27) begrenzen, die sich entlang einer Seite der Kabeldurchführung (11) erstreckt, **gekennzeichnet durch**
eine Umschlagklappe (13), die im Bereich derjenigen Kabeldurchführungsseite an dem Körper (12) angelenkt ist, in welcher die Daueröffnung (27) begrenzt ist, wobei diese Umschlagkappe (13) beweglich ist, so dass die gegenüber der Zwischenwand (19) umgeklappt oder von dieser beabstandet ist, wobei das Fach (14) dazu bestimmt ist, Kommunikationskabel (16) aufzunehmen, wobei die Zwischenwand (19) dazu bestimmt ist, Leistungskabel (28) an ihrer dem Fach (14) entgegengesetzten Fläche zu tragen, wobei die Umschlagklappe (13) dazu bestimmt ist, an ihrer der Zwischenwand (19) entgegengesetzten Fläche Module (42) zu tragen, die jeweils mit zumindest einem Kommunikationskabel (16) und zumindest einem Leistungskabel (28) verbunden sind.

2. Kabeldurchführung nach Anspruch 1, wobei der Körper (12) aus einem gebogenen Blech gebildet ist, um den Boden (17) und die Zwischenwand (19) zu bilden.

3. Kabeldurchführung nach Anspruch 2, wobei der Körper (12) eine Flanke (18) umfasst, die das Fach (14) zusammen mit dem Boden (17) und der Zwischenwand (19) begrenzt, wobei diese Flanke (18) sich in der Verlängerung des Bodens (17) auf der der Zwischenwand (19) entgegengesetzten Seite erstreckt, wobei diese Flanke (18) sich im rechten Winkel zum Boden (17) erstreckt, wobei die Zwischenwand (19) eine schräge Ausrichtung bezüglich des Bodens (17) hat.

4. Kabeldurchführung nach Anspruch 2, wobei die Zwischenwand (19) Lochungen (31) aufweist, die dazu bestimmt sind, Befestigungsschellen (32) für Leistungskabel (28) aufzunehmen.

5. Kabeldurchführung nach Anspruch 2, wobei die Umschlagklappe (13) aus einem Blech gebildet ist, das an dem Körper (12) angelenkt ist und von diesem gehalten ist, indem es an diesen Körper (12) angesteckt ist.

6. Kabeldurchführung nach Anspruch 5, die eine Rückwand (21) umfasst, die sich in der Verlängerung der Zwischenwand (19) erstreckt und dabei bezüglich dieser Zwischenwand (19) umgelegt ist, wobei diese Rückwand (21) Öffnungen bzw. Fenster (37) aufweist, die dazu bestimmt sind, entsprechende Laschen (38) aufzunehmen, die von einem Rand der Umschlagklappe (13) abstehen, um das Anstecken der Umschlagklappe (13) an den Körper (12) und ihre Anlenkung sicherzustellen.

7. Niederspannungs-Schaltschrank mit zumindest einer Kabeldurchführung (11) nach einem der vorangehenden Ansprüche.

## Claims

1. Raceway (11) for a low voltage cabinet, including a body (12) comprising a bottom (17) and an intermediate wall (19) jointly delimiting a compartment (14) with a permanent opening (27) extending along one side of the raceway (11), and a flap (13) hinged on the body (12) at the side of the raceway in which the permanent opening (27) is delimited, this flap (13) being mobile so that it can be folded to face the intermediate wall (19) or to be separated from it, the compartment (14) being designed to hold communication cables (16), the intermediate wall (19) being designed to hold power cables (28) on its face opposite the compartment (14), the flap (13) thus being designed to support modules (42) on its face opposite the intermediate wall (19), each module being connected to at least one communication cable (16) and at least one power cable (28).

2. Raceway according to claim 1, in which the body (12) is composed of a folded metal plate to form the bottom (17) and the intermediate wall (18).

3. Raceway according to claim 2, in which the body (12) comprises a side (18) delimiting the compartment (14) jointly with the bottom (17) and the intermediate wall (19), this side (18) being a continuation of the bottom (17) of the side opposite the intermediate wall (19), this side (18) making a right angle with the bottom (17), the orientation of the intermediate wall (19) being oblique relative to the bottom (17).

4. Raceway according to claim 2, in which the intermediate wall (19) comprises holes (31) that will contain attachment collars (32) for the power cables (28).

5. Raceway according to claim 2, in which the flap (13) is formed by a plate hinged on the body (12) and is supported by the body, being engaged on this body.

6. Raceway according to claim 5, including a return (21) extending along the extension to the intermediate wall (19), being folded relative to this intermediate wall (19), this return (21) comprising openings or windows (37) into which corresponding tabs (38) will fit projecting from one edge of the flap (13), to engage the flap (13) on the body (12) and its hinge.

7. Low voltage cabinet (11) according to any one of the above claims.
